# EUROPEAN PATENT APPLICATION

(11) **EP 2 813 744 A1**
(43) Date of publication of application: **17.12.2014**
(21) Application number: 13171943.7
(22) Date of filing: 14.06.2013
(51) Int. Cl.: F16M 13/02

(54) **Control device for call control**

(71) Applicant: Sennheiser Communications A/S, 2750 Ballerup (DK)
(72) Inventor: Essabar, Mohamad, 2680 Solroed Strand (DK); Værum, Peter Vestergaard, 2680 Solroed Strand (DK); Kaulfuss, Johannes Sejr, 2680 Solroed Strand (DK); Kofod, Jens Brandt, 2680 Solroed Strand (DK)
(74) Representative: Nielsen, Hans Jørgen Vind

(57) **Abstract**

A control device (2) for call control and a system (1) comprising such control device (2) is disclosed. The control device (2) is configured to be electrically connected to an external device (72), such as a computer (72), through a first electrical cable (22), where the control device (2) is configured to be electrically connected to a headset (70) through a second electrical cable (24), where the control device (2) comprises adjustment means (10, 12, 14, 16). The control device (2) comprises means for being detachably attached to a fixation member (8, 8') that is configured to be permanently attached to a firm and solid member (26, 28).

## Description

### Field of invention

The present invention generally relates to a control device for call control. The invention more particularly relates to a control device that is electrically connected to a headset and an external device, such as a computer, where the control device comprises adjustment means for call control.

### Prior art

Control devices for call control are widely used. One usual way of attaching electronic device, like control device for call control, to a support, is to apply a clamping device. A typical control devices for call control is connected to an electrical cable to a headset and an electrical cable to a telecommunication terminal (the point at which a signal enters and/or leaves a network) like a USB interface of a computer. These cables are normally fixedly connected with a clamping device that is configured to be attached by use of a clamp/clip, for example to a garment.

JP 2001128275 A suggests a fastening device that is adapted to be fastened to a garment. There are several disadvantages associated with the use of such fastening devices. It can be very difficult and challenging for the user to find a control device that is hanging from the garment.

For clip solutions like the one suggested in JP 2001128275 A the clip has to be attached and detached each time the user needs to move away from the working station. This is time consuming and introduces risk of unintendedly damaging either the clip or the control device fixed to it the clip. Another disadvantage of devices of this type is, that the garment may be damaged by the clips.

EP 1341361 A2 discloses an attachment device that allows the user to e attach electronic devices to the garment of the user by means of magnetic force. This solution also suffers from the drawback that it has to be attached and detached each time the user needs to move away from the working station. Further, the attachment device is bulky and stands out from the surface to which it is fixed.

Accordingly, there is need for a control device that reduces or even eliminates these drawbacks of the prior art.

Therefore, it is an object of the present invention to provide a control device and a system comprising a control device that does not have to be attached and detached each time the user leaves the working station.

It is also an object of the present invention to provide a control device and a system comprising a control device that is easy to find for the user, and that is secured in a reliable manner and enables fast and easy attachment and detachment of the control device.

### Summary of the invention

The object of the present invention can be achieved by a control device as defined in claim 1 and by a system as defined in claim 2. Preferred embodiments are defined in the dependent sub claims and explained in the following description and illustrated in the accompanying drawings.

The control device according to the invention is a control device for call control, where the control device is configured to be electrically connected to an external device, such as a computer, through a first electrical cable, where the control device is configured to be electrically connected to a headset through a second electrical cable, where the control device comprises adjustment means. The control device comprises means for being detachably attached to a fixation member that is configured to be permanently attached to a firm and solid member.

Hereby it is achieved that the control device does not have to be attached and detached each time the user needs leaves the working station. Moreover, the control device can easily be located by the user, and finally the control device is secured in a reliable manner that enables fast and easy attachment and detachment of the control device.

The term "call control" refers to call controlling features such as volume regulation (turning up or turning down) the headset volume, mute (e.g. muting the line to eliminate noise when the user is not talking), call (dial-out) and terminating a call (disconnection of every line from the call), record (start/stop a digital recording), lecture mode (where everyone except the speaker is muted) and participant count (counting of the number of people that are on the call).

The electrical connection between the control device and the external device and between the control device and the headset may be an electrical cable that optionally may have one more electrical connections (e.g. electrical plugs).

The external device may be a computer having access to a network, through which a call can take place. It is preferred that the external device comprises a telecommunication terminal (the point at which a signal enters and/or leaves the network) such as a USB interface of a computer.

By the term "adjustment means" is meant means for carrying out the previously mentioned call controlling features such as volume regulation (turning up or turning down) the headset volume, mute (e.g. mute your line when you're not talking to eliminate noise), call (dial-out) and terminating a call (disconnection of every line from the call), record (start/stop a digital recording), lecture mode (where everyone except the speaker is muted) and participant count (counting of the number of people that are on the call).

The means for being detachably attached to a fixation member ensures that the control device can be (easily) detached from the fixation member.

The fixation member is configured to be permanently attached to a firm and solid member. The term "permanently attached" refers to an attachment where the fixation member is attached to the firm and solid member by being imbedded in it, by permanently resting upon it, or by being attached to it by means of glue, adhesive (e.g. double-sided adhesive tape), cement, nails, bolts, screws or similar means.

By the term "firm and solid member" is meant a firm and solid object suitable of receiving a fixation member being permanently attached to it. Such firm and solid object may be a table having a firm and solid table top or table edge. When a table top or edge is used as the firm and solid member, it is important that the fixation member is relatively flush with the surface of the table top or edge, such that garments or work pieces on the table top are not hampered by the presence of the fixation member.

It is preferred that the adjustment means includes means for volume adjustment and/or means for answering a call and/or disconnecting a call and/or means for muting the call.

The system according to the invention is a system comprising a control device according to claim 1. The system comprises a fixation member and the control device comprises means for being detachable attached to the fixation member. The fixation member is configured to be permanently attached to a firm and solid member.

It may be an advantage that the control device comprises a basically box-shaped body comprising a base member and a lid member configured to be attached to the base member and that the means for being detachably attached to the fixation member are provided at the rear side of the base member.

Hereby it is possible to provide a secure and reliable detachably attachment of the base member to the fixation member and at the same time provide a body that is configured to receive a printed circuit board in a space provided between the base member and the lid member. In this manner the user may have access to control an interface integrated in the lid member of the control device.

It may be beneficial that the control device comprises an elongated body and that a first electrical cable extending along the longitudinal axis of the control device enters the control device in a first end of the body and that a second electrical cable extending along the longitudinal axis of the control device enters the control device in a second end of the body.

Hereby a compact and user-friendly control device can be provided. A control device of this kind is suitable of being electrically connected to an external device such as a USB interface of a computer by means of the first electrical cable and to a headset by means of the second electrical cable.

It may be beneficial that a basically box-shaped track member is provided at the rear side of the body and that the track member is configured to receive and hereby be attached to the fixation member. In this way the box-shaped track member will surround the fixation member on all sides, apart from the side facing the table top, and such track member provides a simple and reliable locking member suitable of securing that the control device is kept fixed to the fixation member.

It may be an advantage that a recess is provided, preferably centrally, at a track side edge of the body and/or that the track member comprises a plane base surface.

Hereby the attachment and detachment of the body of the control device is eased. It is preferred that the recess has a geometry that allows the user of the control device to get hold of the body with the fingers when gripping the body, while the body is attached to a fixation member. Thus gripped the electronic device may be lifted off of the fixation member with one hand.

It may be advantageous that the length of the track member is significantly larger than the length of the recess.

In one embodiment of the device according to the invention, the length of the track member is approximately twice as long as the length of the recess.

Hereby it is possible to maintain a high mechanical strength of the base member and at the same time provide a recess that is accessible by the fingers of the user of the control device.

It may be an advantage that the control device is configured to be attached to the fixation member by means of magnetic attraction and that at least one, preferably two or more permanent magnets are provided inside the body or attached to the outside of the body of the control device, where the fixation member comprises at least one permanent magnet or is at least partly made in a ferromagnetic or ferrimagnetic material.

Hereby it is possible to provide a fast, easy and user-friendly detachably attachment of the body of the control device to the fixation member.

It may beneficial that the control device is configured to be attached to the fixation member by means of magnetic attraction and that at least one, preferably two or more permanent magnets are attached to or integrated into the fixation member, where the base member of the body of the control device comprises an attachment member made in a ferromagnetic or ferrimagnetic material or comprising at least one permanent magnet, where the attachment member is configured to be detachably attached to the fixation member by means of magnetic attraction.

This is an alternative way of providing a fast, easy and user-friendly detachably attachment of the body of the control device to the fixation member.

It may be an advantage that one or more, preferably two or more light emitting diodes are provided in the lid member. These light emitting diodes may be configured to indicate predefined states of use e.g. by changing colour and/intensity of the light.

It may be favorable that the control device is configured to be detachably attached to the fixation member by means of mechanical attachment means.

The use of mechanical means attachment means may make it possible to provide a reliable control device and system that at the same time is simple and cheap to manufacture.

It may be advantageous that the body of the control device comprises means for preventing displacement of the body of the control device both along the longitudinal axis of the control device and along the lateral axis of the control device.

Hereby the control device can be kept in a fixed position relative to the fixation member so that the user always knows where to find the control device. This is obtained without compromising the requirement that the fixation member remains essentially flush with the table top surface.

It is preferred that the control device comprises a first electrical cable or a connection configured to be electrically connected to an external device and that the control device comprises a second electrical cable or a connection configured to be electrically connected to a headset. The first and second electrical cables may be integrated in the control device. The control device may alternatively comprise electrical connections suitable for being connected to electrical cables to an external device and a headset, respectively.

A system comprising such control device is suitable for being used within a call control in a typical setup, where the control device is connected to an electrical cable to a headset and an electrical cable to a telecommunication terminal (e.g. a USB interface of a computer).

It may be an advantage that the fixation member is provided with double-sided adhesive tape configured to permanently attach the fixation member to the firm and solid member.

Such fixation method is easy, fast and user-friendly.

It may be an advantage to provide the fixation member with a number of through going holes configured to receive screws so that the fixation member is suitable of being attached to a firm and solid member by means of screws, bolts or nails.

It is possible to attach the fixation member to a firm and solid member by means of glue or adhesive.

It may be advantageous that the control device comprises two or more, preferably four buttons protruding from the upper surface of the lid member.

Hereby, it is easier to get hold of and use the buttons.

It is may be an advantage that the buttons protruding from the upper surface of the lid member are press buttons.

It is preferred that the control device is adapted to be connected to the Universal Serial Bus (USB) port of a computer and that the control device is adapted to be connected a headset and that the control device is configured to adjustably control the volume of a call and to mute and answer/end a call.

In one embodiment of the system according to the invention the control device comprises one or more permanent magnets or one or more electromagnets arranged in such a manner that the control device can be detachably attached to a fixation member formed as a metal plate configured to be fixed to the upper or lower surface of a table top or to a table edge of a table.

Hereby it is possible to provide easy access to the control buttons for the user. Moreover, the user always knows where to find the control device.

It may be an advantage that the size, strength and position of the magnets is selected in such a way that in case the user wants to leave the working station the magnets will release when pulling the electrical cables of the control device.

### Description of the Drawings

The invention will become more fully understood from the detailed description given herein below. The accompanying drawings are given by way of illustration only, and thus, they are not limitative of the present invention. In the accompanying drawings:
- Fig. 1: shows a perspective view of a system according to the invention;
- Fig. 2 a): shows a perspective view of a control device according to the invention;

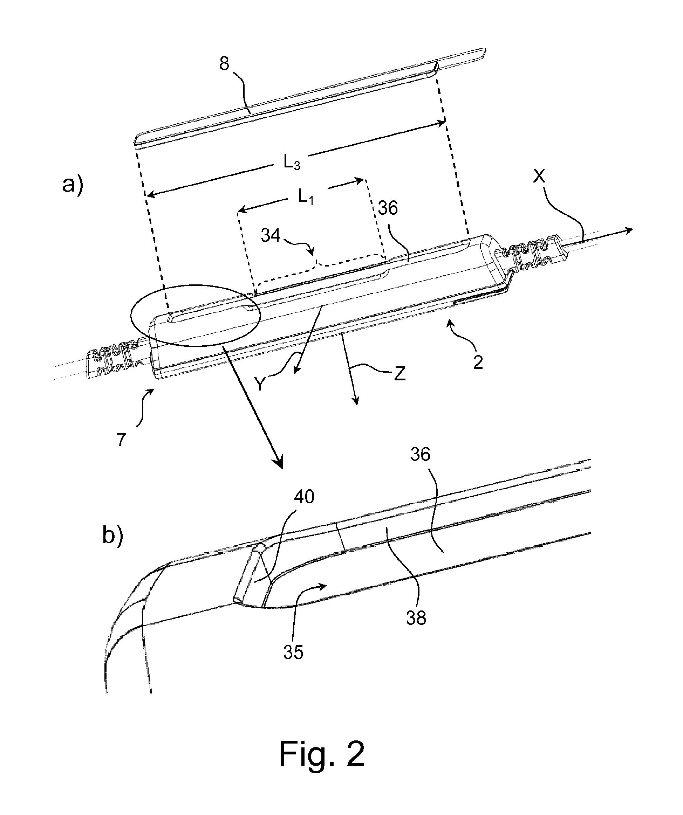

- Fig. 2 b): shows a close-up view of a control device;

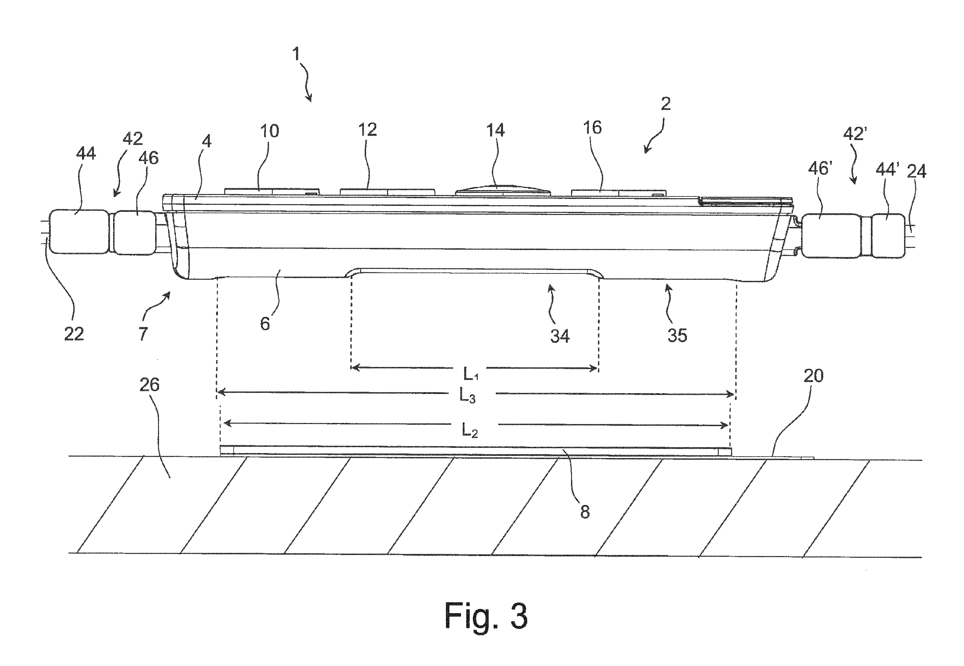

- Fig. 3: shows a side view of a system comprising a control device arranged above a fixation member according to the invention;

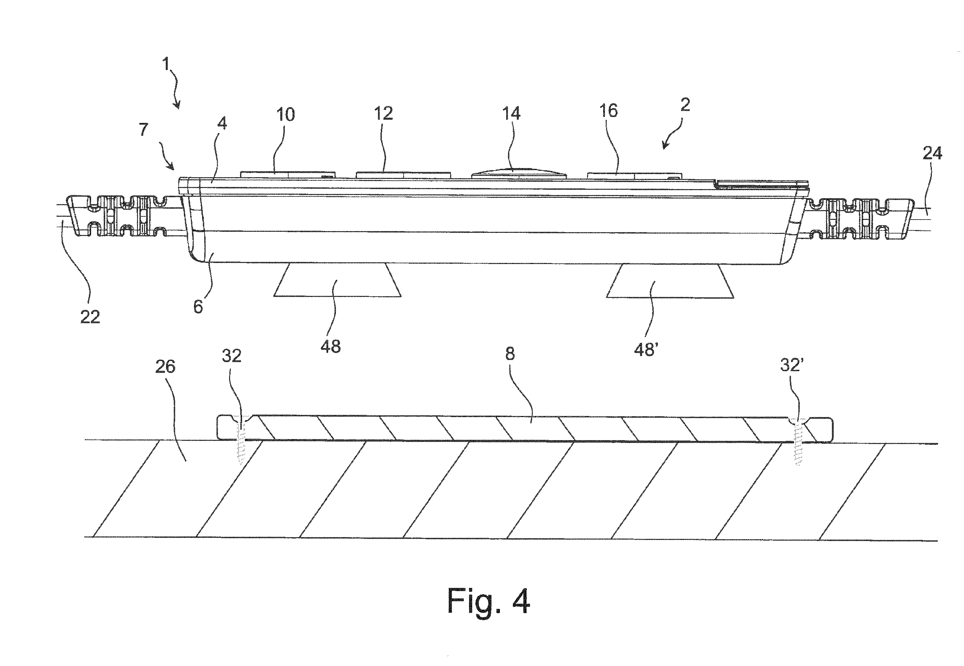

- Fig. 4: shows a side view of a system according to the invention, where the control device is configured to be attached to a fixation member by means of suction discs;

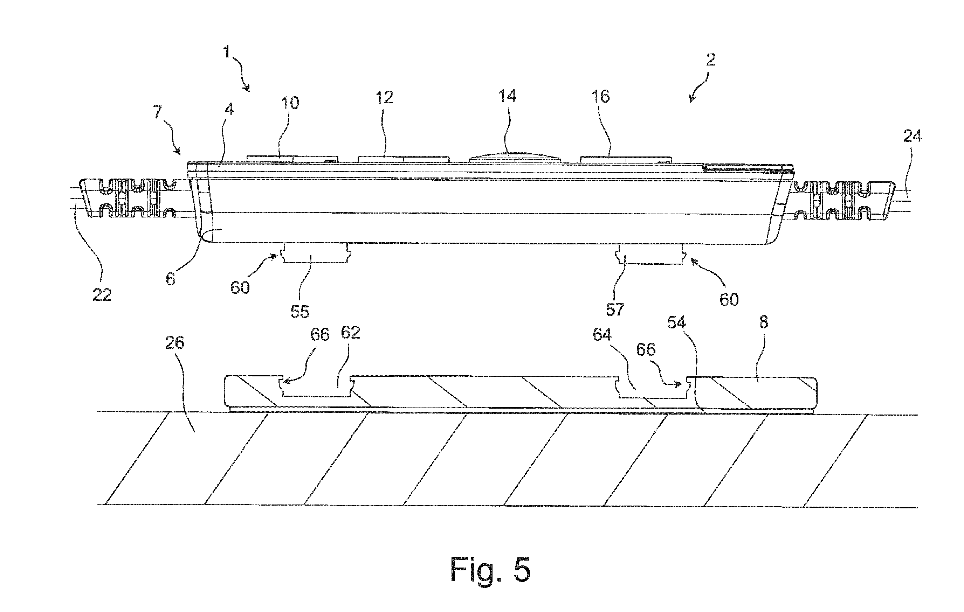

- Fig. 5: shows a side view of a system according to the invention, where the control device is configured to be attached to a fixation member by means of mechanical attachment means;

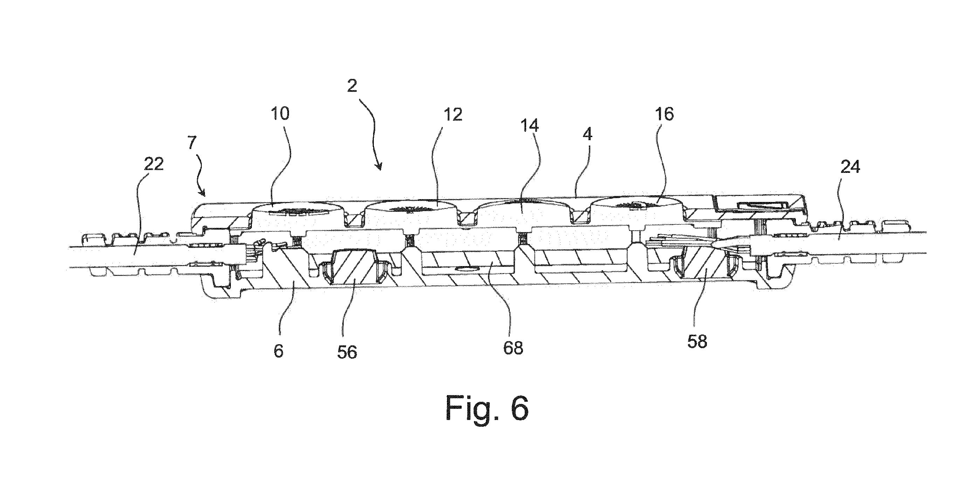

- Fig. 6: shows a cross-sectional view of a control device according to the invention;

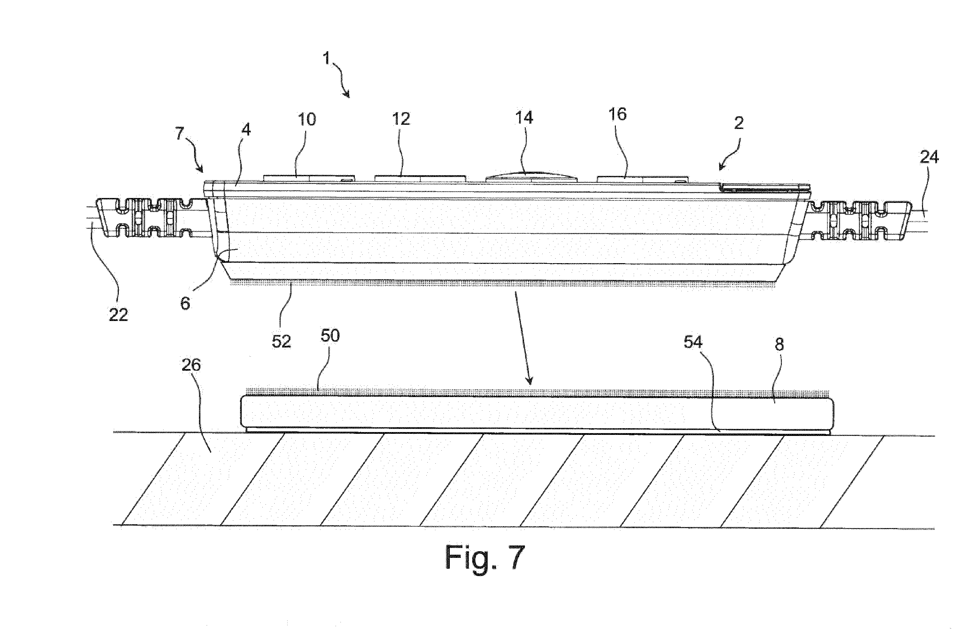

- Fig. 7: shows a side view of a system according to the invention, where the control device is configured to be attached to a fixation member by means of hook-and-loop fasteners;

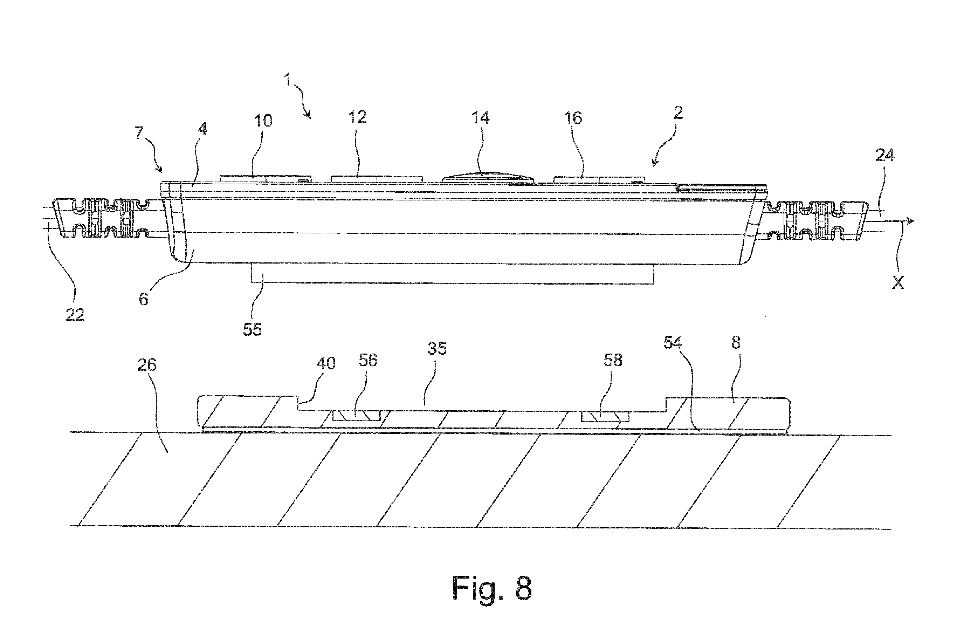

- Fig. 8: shows a side view of a system according to the invention, where the control device is configured to be attached to a fixation member by means of magnetic and mechanical attachment and

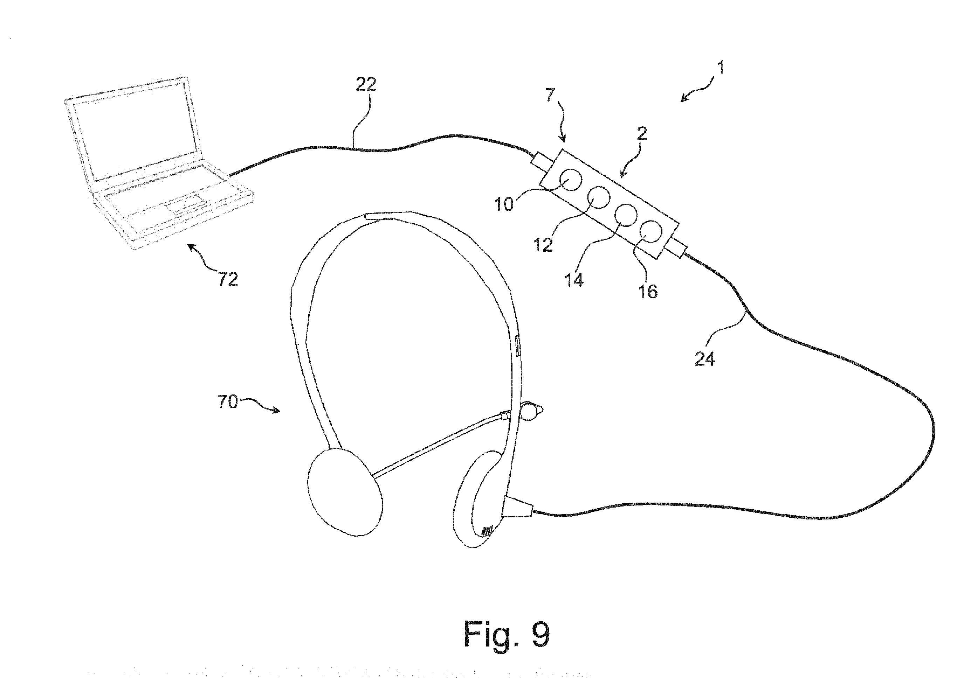

- Fig. 9: shows a system according to the invention comprising a control device electrically connected to a computer and a headset.

### Detailed description of the invention

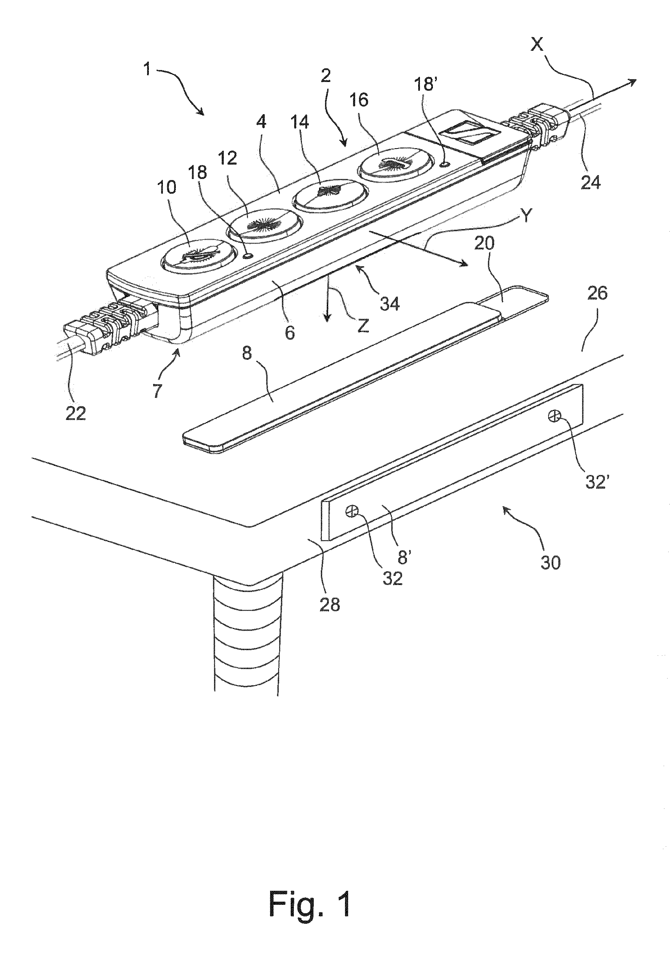

Referring now in detail to the drawings for the purpose of illustrating preferred embodiments of the present invention, different views of a system 1 according to the invention is illustrated in Fig. 1.

The system 1 comprises a control device 2 configured to be electrically connected to an external device (not shown) providing access to a network (e.g. a computer or a mobile phone) by means of an electrical cable 22. The control device 2 is also configured to be electrically connected to a headset (see Fig. 9) by means of an electrical cable 24.

The control device 2 has an elongate basically boxed-shaped body 7 comprising a base member 6 and a lid member 4 that is attached to the base member 6. The base member 6 and the lid member 4 may be attached to each other by any suitable attachment means like ultrasonic welding, gluing or by means of mechanical attachment means like a press-fit connection or screws.

Two light emitting windows 18, 18' are provided in the lid member 4. On the print below the windows, light emitting diodes will radiate the light to be emitted through the windows. These light emitting windows 18, 18' may be configured to indicate predefined states of use e.g. by changing colour and/intensity of the light.

A first press button 10 formed as a mute button is provided at the first end segment of the control device 2. Next to the mute button 10 a volume reduction control button 12 is arranged. Next to the volume reduction control button 12 a volume increasement button 14 is provided. Finally, a button 16 to answer and disconnect a call is provided at the right section of the control device next to the volume increasement button 14. The buttons 10, 12, 14, 16 slightly protrude from the upper surface of the lid member 4. Hereby, it is easier to get hold of and use the buttons 10, 12, 14, 16 by the user. By the provision of the buttons 10,12,14,16 one after the other in the longitudinal direction, on the top side, they are easily depressed with finger touch and also the sides of the device in the lateral direction is kept free to be gripped by the user without interfering with the buttons.

A recess 34 is provided at the back side of the base member 6. A plate-shaped fixation member 8 is permanently attached to a table top 26 of a table 30. The fixation member 8 is attached to the table top 26 by means of double-sided adhesive tape 20. This means that the fixation member 8 is configured to be kept in the same location on the table top 26. The control device 2 has a longitudinal axis X, a lateral axis Y extending along the width of the control device 2 and a third axis Z extending along the thickness of the control device. The lateral axis Y and a third axis Z are perpendicular to each other and to the longitudinal axis X.

A fixation member 8' may be permanently attached to the table 30 by means of two screws 32, 32'. The fixation member 8, 8' may be attached to the side, top or underside of the table 26. The control device 2 is configured to be detachably attached to either the fixation member 8 fixed to the table top 26 of the table 30 or the fixation member 8' fixed to the table edge 28 of the table 30.

In a preferred embodiment of the control device 2 according to the invention, a number of permanent magnets (see Fig. 6) are integrated in the control device 2. The fixation member 8, 8' is made in a ferromagnetic or ferrimagnetic material. The permanent magnets and the fixation member 8, 8' are attracted to one another by magnetic attraction. Accordingly, it is possible to provide a detachable attachment of the control device 2 to the fixation member 8, 8'.

Fig. 2 illustrates two perspective views of a control device 2 according to the invention. In Fig 2 a) the rear side of the control device 2 is visible. It can be seen that a track member 35 is provided in the rear side of the body 7 of the control device 2. The track member 35 is basically box-shaped and has a plane base surface 36. A recess 34 is provided centrally at track side edge 38.

The length L₃ of the track member 35 is significantly larger than the length L₁ of the recess 34. It can be seen that the track member 35 is configured to receive and hereby be attached to the fixation member 8. The fixation member is covered in this way and the control device 2 is barred from moving sideways. Also this ensures a fixation member 8, 8' which does not protrudes and provided attachment sites for garments or papers or other articles at or near the table.

In a preferred embodiment according to the invention the control device 2 is configured to be attached to the fixation member 8 by means of magnetic attraction.

It may be preferred that two permanent magnets are provided inside the control device 2, so that the control device 2 can be attracted to a fixation member 8 at least partly made in a ferromagnetic or ferrimagnetic material. The control device 2 can then be attached to the attracted fixation member 8 due to the magnetic attraction.

It is also possible to apply a magnetic fixation member 8 and integrate ferromagnetic or ferromagnetic elements in the control device 2 so that the control device 2 is attracted to the fixation member 8.

If the control device 2 is manufactured in a plastic material it would be an advantage to arrange metal elements inside the control device 2. However, it would also be possible to provide a metal element at the outside surface of the control device 2 or alternative simply make a control device 2 in metal (a ferromagnetic or ferromagnetic material).

Fig. 2 b) illustrates a close-up view of the track member 35 of the control device 2 shown in Fig. 2 a). The track member 35 has a plane base surface 36, two track side edges 38 and two track end edges 40. The track side edges 38 and the track end edges 40 extend basically perpendicular to the base surface 36.

The control device 2 has a longitudinal axis X, a lateral axis Y and a third axis Z as illustrate in Fig. 1. The two track side edges 38 prevent the control device 2 from moving along its Y-axis, while the end edges 40 prevent the control device 2 from moving along its X-axis when the control device 2 is attached to the fixation member 8. The magnetic attraction between the fixation member 8 and the (magnets of the) control device 2 prevents the control device 2 from moving along its Z-axis.

Fig. 3 illustrates a side view of a system 1 according to the invention. The system 1 comprises a control device 2 like the one shown in Fig. 1 and Fig. 2. The control device 2 is arranged above a fixation member 8 that is attached to a table top 26 by means of double-sided adhesive tape 20. It can be seen that the first press button 10, the volume reduction control button 12 and the "answer and disconnect" button 16 all have a flat and plane top surface while the volume increasement button 14 has an arched top surface. The buttons 10, 12, 14, 16 slightly protrude from the upper surface of the lid member 4 of the body 7 in order to give the user better access to the buttons 10, 12, 14, 16.

The recess 34 provided in the base member 6 of the control device 2 has a length L₁ that corresponds to approximately half the length L₃ of the track member 35 provided in the base member 6. The length L₂ of the fixation member 8 is slightly smaller than the length L₃ of the track member 35.

The control device 2 is electrically connected to an external device (not shown) via an electrical cable 22 that is connected to the control device 2 by an electrical connection 42 comprising first electrical connector 46 of the control device 2 and a second electrical connector 44 of the cable 22. The connector 44, 46 may be detachable plugs or may be permanent connectors. In fig. 6 permanent connectors are shown.

In the opposite end of the control device 2, the control device 2 is electrically connected to a headset (not shown) via an electrical cable 24. The cable 24 is connected to the control device 2 by an electrical connection 42' comprising first electrical connector 46' of the control device 2 and a second electrical connector 44' of the cable 24. Accordingly, the control device 2 is configured to be connected to and disconnected from the external device and the headset.

Fig. 4 illustrates a side view of another system 1 according to the invention. The system 1 comprises a control device 2 that is configured to be attached to a fixation member 8 by means of suction discs 48, 48' provided at the rear side of the body 7 of the control device 2. The control device 2 is basically similar to the one shown in Fig. 1-3; however, two suction discs 48, 48' are attached to the rear side of the base member 6 of the control device 2. Even if not shown in Fig. 4, a track member 35 may be provided to surround the fixation member 8 in order to prevent sideways movement of the device.

The fixation member 8 is attached to the subjacent table top 26 by means of countersunk screws 32, 32'. Thus, the fixation member 8 is permanently attached to the table top 26, while the control device 2 is configured to be detachably attached to the fixation member 8. The control device 2 is configured to be attached to the fixation member 8 by pressing the suction discs 48, 48' towards the fixation member 8 and hereby evacuating the air within the suction discs 48, 48' so that a vacuum is created within the suction discs 48, 48'. The pressure difference between the atmosphere on the outside of the suction discs 48, 48', and the low-pressure cavity inside the suction discs 48, 48' keeps the suction discs 48, 48' adhered to the table top 26.

Fig. 5 illustrates a side view of a system 1 according to the invention. The system 1 comprises a control device 2 that is configured to be attached to a fixation member 8 by means of mechanical attachment means 60, 66 that are fixed to the rear side of the body 7 of the control device 2. The control device 2 comprises two attachment members 55, 57 each provided with rib members 60. The attachment members 55, 57 are adapted to be received by corresponding holes 62, 64 in the fixation member 8 and the rib members 60 are configured to be received by corresponding cavities 66 provided in the side wall of the holes 62, 64.

The attachment members 55, 57 are preferably made in a resilient material like a soft silicone material, or an elastomer such as natural rubber. The fixation member 8 may be made in metal or a plastic material by way of example. The fixation member 8 is permanently attached to the table top by means of glue 54.

Fig. 6 illustrates a schematically cross-sectional view of a control device 2 according to the invention. The control device 2 comprises a body 7 having a base member 6 made in a plastic material and a lid member 4 that is attached to the base member 6. A printed circuit board 68 is provided within the interior of the control device 2.

The printed circuit board 68 contains all the means necessary to control the signals received from the extern device (not shown) through a first electrical cable 22. The control device 2 also comprises a second electrical cable 24 that is connected to a headset (not shown).

It can be seen that the first press button 10, the volume reduction control button 12, the volume increasement button 14 and the "answer and disconnect" button 16 protrude from the upper surface of the lid member 4 and that these buttons 10, 12, 14, 16 are electrically connected to the printed circuit board 68. Accordingly, it is possible to operate the control device 2 by use of the buttons 10, 12, 14, 16 and hereby provide the required control of the control device 2.

A first permanent magnet 56 is provide in a first cavity within the base member 6 of the control device 2 and a second permanent magnet 58 is provided in the second cavity within the base member 6 of the control device 2. The magnets 56, 58 are arranged in a close distance to the rear side of the base member 6. Hereby, the base member 6 can be attached to a fixation member 8 made in a ferromagnetic or ferrimagnetic material. The distance between the magnets 56, 58 and the fixation member 8 is important since the magnetic field strength of the magnets 56, 58 decreases as function of the distance between the magnets 56, 58 and the fixation member 8.

Fig. 7 illustrates a side view of another system 1 according to the invention. The system 1 comprises a control device 2 configured to be attached to a fixation member 8 by means of hook-and-loop fasteners 50, 52. The fixation member 8 is attached to a table top 26 by means of glue 54.

The control device 2 is basically equal to the control device 2 shown in Fig. 1-6 except from the rear side of the base member 6 of the body 7. The rear side of the base member 6 is provided with a plate member that is covered with hook-and-loop fasteners 52 and the top surface of the fixation member 8 is covered by a layer of hook-and-loop fasteners 50 configured to be attached to the hook-and-loop fasteners 52 of the base member 6. Also in this embodiment, a track member 54 may be provided for stability and to ensure correct seating of the device on the fixation member.

Fig. 8 illustrates a side view of a system 1 according to the invention. The system 1 comprises a control device 2 having a body 7 that is configured to be attached to a fixation member 8 by means of magnetic and mechanical attachment. The control device 2 is provided with a base member 6 that is equipped with a box-shaped elongated attachment member 55 made in a ferromagnetic or ferrimagnetic material. The attachment member 55 is configured to be received by a track member 35 provided in the fixation member 8.

Two permanent magnets 56, 58 are provided in the track member 35 of the fixation member 8. These magnets 56, 58 are adapted to provide the required magnetic force in order to keep the attachment member 55 fixed to the fixation member 8. The track end edge 40 of the track member 35 prevents the control device 2 from moving along the longitudinal axis X of the control device 2.

The fixation member 8 is attached to the table top 26 by means of glue; however, other attachment means (e.g. screws or doubled-sided adhesive tape) may be used.

Fig. 9 illustrates a system 1 according to the invention. The system 1 comprises a control device 2 having a body 7 that is electrically connected to a mobile phone 72 via an electrical cable 22 and to a headset 70 via an electrical cable 24. The control device 2 is configured to control web-based calls.

The headset 70 has a double-sided design; however, a single-sided design is also possible. The headset 70 may comprise a noise cancelling microphone.

The control device 2 comprises a first mute button 10, volume reduction control button 12, a volume increasement button 14 and a "answer and disconnect" button 16.

The control device 2 is simple to use and enables the user to make calls, mute the microphone or adjust the volume by using the press buttons 10, 12, 14, 16. These buttons 10, 12, 14, 16 can be used to fully adjust the volume and mute a phoning session directly from the headset.

It is preferred that the headset 70 comprises a built-in USB sound card configured to deliver enhanced sound quality regardless of the extern device 72 that the control device 2 is connected to.

In a preferred embodiment according to the invention the control device 2 is adapted to be connected to the Universal Serial Bus (USB) port of the computer 72. Hereby the control device 2 can easily be used to phone over the Internet.

### List of reference numerals

- 1: - System
- 2: - Control device
- 4: - Lid member
- 6: - Base member
- 7: - Body
- 8, 8': - Fixation member
- 10, 12, 14, 16: - Press button
- 18, 18': - Light emitting diode (LED)
- 20: - Double-sided adhesive tape
- 22, 24: - Electrical cable
- 26: - Table top
- 28: - Table edge
- 30: - Table
- 32, 32': - Screw
- 34: - Recess
- 35: - Track member
- 36: - Base surface
- 38: - Track side edge
- 40: - Track end edge
- 42, 42': - Connection
- 44, 44', 46, 46': - Connector
- 48, 48': - Suction disc
- 50, 52: - Hook-and-loop fastener
- 54: - Glue
- 55, 57: - Attachment member
- 56, 58: - Magnet
- 60: - Rib member
- 62, 64: - Hole
- 66: - Cavity
- 68: - Printed circuit board (PCB)
- 70: - Headset
- 72: - External device
- L₁, L₂, L₃: - Length
- X, Y, Z: - Axis

## Claims

1. A control device (2) for call control, where the control device (2) is configured to be electrically connected to an external device (72), such as a computer (72), through a first electrical cable (22), where the control device (2) is configured to be electrically connected to a headset (70) through a second electrical cable (24), where the control device (2) comprises adjustment means (10, 12, 14, 16) **characterised in that** the control device (2) comprises means for being detachably attached to a fixation member (8, 8') that is configured to be permanently attached to a firm and solid member (26, 28).

2. A system (1) comprising a control device (2) according to claim 1 **characterised in that** the system (1) comprises a fixation member (8, 8') and that the control device (2) comprises means (35, 36, 38, 40, 48, 48', 52, 55, 56, 57, 58, 60) for being detachable attached to the fixation member (8, 8') and that the fixation member (8, 8') is configured to be permanently attached to a firm and solid member (26, 28).

3. A system (1) according to claim 2 **characterised in that** the control device (2) comprises a basically box-shaped body (7) comprising a base member (6) and a lid member (4) configured to be attached to base member (6) and that the means (35, 36, 38, 40, 48, 48', 52, 55, 56, 57, 58, 60) for being detachably attached to the fixation member (8, 8') are provided at the rear side of the base member (6).

4. A system (1) according to claim 3 **characterised in that** the control device (2) comprises an elongated body (7) and that a first electrical cable (22) extending along the longitudinal axis (X) of the control device (2) enters the control device (2) in a first end of the body (7) and that a second electrical cable (24) extending along the longitudinal axis (X) of the control device (2) enters the control device (2) in a second end of the body (7).

5. A system (1) according to one of the claims 2-4 **characterised in that** a basically box-shaped track member (35) is provided at the rear side of the body (7) and that the track member (35) is configured to receive and hereby be attached to the fixation member (8, 8').

6. A system (1) according to claim 5 **characterised in that** a recess (34) is provided, preferably centrally, at a track side edge (38) of the body (7) and/or that the track member (35) comprises a plane base surface (36).

7. A system (1) according to claim 6 **characterised in that** the length (L₃) of the track member (35) is significantly larger than the length (L₁) of the recess (34).

8. A system (1) according to one of the claims 2-7 **characterised in that** the control device (2) is configured to be attached to the fixation member (8) by means of magnetic attraction and that at least one, preferably two or more permanent magnets (56, 58) are provided inside the body (7) or attached to the outside of the body (7) of the control device (2), where the fixation member (8) comprises at least one permanent magnet (56, 58) or is at least partly made in a ferromagnetic or ferrimagnetic material.

9. A system (1) according to one of the claims 2-7 **characterised in that** the control device (2) is configured to be attached to the fixation member (8) by means of magnetic attraction and that at least one, preferably two or more permanent magnets (56, 58) are attached to or integrated into the fixation member (8), where the base member (6) of the body (7) of the control device (2) comprises an attachment member (55) at least partly made in a ferromagnetic or ferrimagnetic material or comprising at least one permanent magnet, where the attachment member (55) is configured to be detachably attached to the fixation member (8) by means of magnetic attraction.

10. A system (1) according to one of the claims 2-7 **characterised in that** the control device (2) is configured to be attached to the fixation member (8) by means of mechanical attachment means (48, 48', 52, 54, 55, 56, 58, 60).

11. A system (1) according to one of the claims 2-10 **characterised in that** the body (7) of the control device (2) comprises means (38, 40) for preventing displacement of the body (7) of the control device (2) both along the longitudinal axis (X) of the control device (2) and along the lateral axis (Y) of the control device (2).

12. A system (1) according to one of the claims 2-11 **characterised in that** the control device (2) comprises a first electrical cable (22) or a connection (42) configured to be electrically connected to an external device (72) and that the control device (2) comprises a second electrical cable (24) or a connection (42') configured to be electrically connected to a headset (70).

13. A system (1) according to one of the claims 2-12 **characterised in that** the fixation member (8) is provided with double-sided adhesive tape (20) configured to be used to permanently attach the fixation member (8) to the firm and solid member (26, 28).

14. A system (1) according to one of the claims 3-13 **characterised in that** the control device (2) comprises two or more, preferably four buttons (10, 12, 14, 16) protruding from the upper surface of the lid member (4).

15. A system (1) according to one of the claims 2-14 **characterised in that** the control device (2) is adapted to be connected to the Universal Serial Bus (USB) port of the computer (72) and that the control device (2) is adapted to be connected a headset (70) and that the control device (2) is configured to adjustably control the volume of a call and to mute and answer/end a call.
